# EUROPEAN PATENT APPLICATION

(11) **EP 4 749 294 A1**
(43) Date of publication of application: **27.05.2026**
(21) Application number: 24843354.2
(22) Date of filing: 27.06.2024
(51) Int. Cl.: G01R 1/04, G01R 1/067, G01R 31/28, G01R 3/00

(54) **SOCKET DEVICE FOR TESTING CIRCUIT OF ELECTRONIC DEVICE**

(30) Priority: 20.07.2023 KR 20230094359; 13.12.2023 KR 20230180979
(71) Applicant: Belink Co., Ltd., Seongnam-si, Gyeonggi-do 13207 (KR); Sae Han Micro Tech Co., Ltd., Namyangju-si, Gyeonggi-do 12018 (KR)
(72) Inventor: PARK, Yeon Ho, Yongin-si, Gyeonggi-do 16994 (KR); PARK, Sang Young, Icheon-si, Gyeonggi-do 17372 (KR); LEE, Jeahyoung, Hwaseong-si, Gyeonggi-do 18441 (KR); KIM, Sukmin, Namyangju-si, Gyeonggi-do 12285 (KR); PARK, Juncheol, Uijeongbu-si, Gyeonggi-do 11800 (KR)
(74) Representative: Schaad, Balass, Menzl & Partner AG
(86) International application number: PCT/KR2024/008987
(87) International publication number: WO 2025/018634

(57) **Abstract**

Disclosed is a socket device for testing a circuit of an electronic device, the socket device having a structure that combines a MEMS pin and metal powder and thus able to handle fine pitches and high-speed testing as well as have an extended lifespan. The socket device for testing a circuit of an electronic device according to one aspect of the present invention may comprise: a MEMS pin having an upper body, a lower body, and an elastic connection member for connecting the upper body and the lower body; a rubber layer having a through-hole in which the MEMS pin is embedded while supported in a standing position; and a metal powder layer including a plurality of metal powder particles and fixed between the MEMS pin and the rubber layer so as to surround the MEMS pin.

## Description

### TECHNICAL FIELD

The present invention relates to a socket device for testing a circuit of an electronic device, and more specifically to a socket device for testing a circuit of an electronic device that is capable of responding to fine pitch and high-speed testing while extending the lifespan by presenting a structure that fuses MEMS pins and metal powder.

### BACKGROUND ART

In general, products formed with circuit patterns, such as semiconductor devices and flat panel displays (FPDs), essentially require a process of testing the electrical status of circuit patterns during the manufacturing process, and the device applied herein can be called a socket device for testing a circuit of an electronic device.

For example, a semiconductor device with an electrical circuit formed on a silicon wafer undergoes an Electrical Die Sorting (EDS) process to test electrical characteristics thereof, and a testing device can perform the EDS process by applying an electrical signal to a chip formed on a silicon wafer, obtaining an electrical signal output from the chip, and determining whether the chip is defective.

According to related art, sockets that are applied to sockets for semiconductor device testing are applied in a variety of products, such as pogo type, rubber type and injection molding plate type.

As semiconductor devices are developed into high-integration, low-power, and ultra-high-speed forms, complex responses from test socket apparatuses are required. They must be able to respond to fine pitch, high speed and high temperature, and the product lifespan must also be maintained to meet customer demands.

In the case of the pogo pin type, there is a physical limitation in responding to fine pitch due to the structure of a pogo pin. Therefore, there was a problem in that the unit price increased rapidly when miniaturization was performed.

Rubber type had a problem in that there is a large difference in characteristics depending on the test temperature, and there was a problem in that when conducting a cold test of a fine pitch product, the characteristics were poor, and the lifespan was rapidly reduced.

The injection molding plate pin type had problems such as ball damage during ball package testing in the burn-in process.

Currently, rubber products using metal powder are mainly used in the fine pitch product group of the memory semiconductor product group, but there is a problem that many problems occur due to rapid reduction in lifespan in high and low temperature tests (Hot/Cold Test) of fine pitch products.

In addition, according to related art, there were problems in which contact was not properly made due to accumulated processing tolerances of structures that perform electrical contact in various ways and members such as pins installed in the structures.

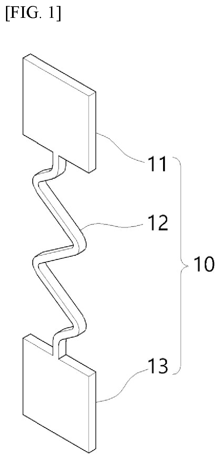

That is, referring to FIG. 1, a conventional MEMS pin 10 may be applied. A MEMS pin 10 has an upper body 11 and a lower body 13, and has a connecting portion 12 that elastically connects between the same. However, since the MEMS pin 10 is manufactured in a thin plate shape, there was a problem in that as the terminal pitch became finer due to the accumulation of processing tolerance, the terminal deviated from the upper surface of the plate shape, resulting in a defect.

### DISCLOSURE

### TECHNICAL PROBLEM

The present invention has been devised to solve the above problems, and an object of the present invention is to provide a socket device for testing a circuit of an electronic device that can respond to fine pitch and high-speed testing and can respond to high temperatures, thereby extending the lifespan of a product.

Another object of the present invention is to provide a socket device for testing a circuit of an electronic device that is capable of securing contact stability through surface contact by applying a MEMS pin and metal powder together to the contact.

The problems of the present invention are not limited to the problems mentioned above, and other problems that are not mentioned will be clearly understood by those skilled in the art to which the present invention pertains from the description below.

### TECHNICAL SOLUTION

According to an aspect of the present invention, provided is a socket device for testing a circuit of an electronic device, including: a MEMS pin having an upper body, a lower body and an elastic connection portion configured to connect the upper body and the lower body; a rubber layer having a through-hole in which the MEMS pin is embedded while being supported in a standing position; and a metal powder layer including a plurality of metal powders and fixed between the MEMS pin and the rubber layer so as to surround the MEMS pin.

According to another aspect of the present invention, provided is a socket device for testing a circuit of an electronic device, including: a MEMS pin having an upper body, a lower body and an elastic connection portion configured to connect the upper body and lower body; a rubber layer having a through-hole in which the MEMS pin is embedded while being supported in a standing position; and a metal powder layer including a plurality of metal powders that are filled into and fixed in a recessed portion formed where a part of the rubber layer is recessed at a position where an upper or lower end part of the MEMS pin is disposed.

In this case, a through-hole of the rubber layer may have a tapered shape.

In this case, an upper film and a lower film may be bonded to upper and lower surfaces of the rubber layer so as to support the MEMS pin.

In this case, a through-hole of a rubber layer through which the MEMS pin penetrates may not be supplied with a rubber material and may be empty.

In this case, a through-hole of a rubber layer through which the MEMS pin penetrates may be filled with a softer rubber material than other parts.

In this case, rubber layers on which a lower body and upper body of the MEMS pin are disposed may be filled with different rubber materials, and a rubber material filled in the upper body may be softer than a rubber material filled in the lower body.

In this case, an elastic connection portion of the MEMS pin may not be provided with a rubber material and may be formed with an air layer.

In this case, the metal powder layer may be disposed to surround the entire MEMS pin, or to surround only an upper body or lower body of the MEMS pin.

In this case, the recessed portion may have a larger area so as to cover an area of an end part of an upper body or lower body of the MEMS pin.

In this case, the socket device may further include: a rubber film layer installed to cover all or part of an upper part of the rubber layer, and having connection terminals at each position corresponding to the MEMS pin such that a height is adjusted for all or part and applied to multiple terminals.

In this case, the rubber film layer may be replaceable.

In this case, the rubber layer may be made of silicone rubber.

### ADVANTAGEOUS EFFECTS

According to the above configuration, the socket device for testing a circuit of an electronic device according to one aspect of the present invention can respond to fine pitch and high-speed testing and can be miniaturized by applying a MEMS pin and metal powder.

The socket device for testing a circuit of an electronic device according to one aspect of the present invention can completely prevent poor contact by increasing a terminal contact area by having metal powder come into contact with a terminal together with the MEMS pin.

The socket device for testing a circuit of an electronic device according to one aspect of the present invention can extend a lifespan, during high-temperature and low-temperature tests by applying MEMS pins to fine-pitch products.

It should be understood that the effects of the present invention are not limited to the effects described above, but include all effects that can be inferred from the configuration of the invention described in the detailed description or claims of the present invention.

### DESCRIPTION OF DRAWINGS

FIG. 1 is a perspective view of a MEMS pin according to related art.
FIG. 2 is a cross-sectional view of a socket device for testing a circuit of an electronic device according to a first embodiment of the present invention.
FIG. 3 is a partially enlarged cross-sectional view of a socket device for testing a circuit of an electronic device according to a first embodiment of the present invention.
FIG. 4 is a partially enlarged cross-sectional view of a socket device for testing a circuit of an electronic device according to a second embodiment of the present invention.
FIG. 5 is a partially enlarged cross-sectional view of a socket device for testing a circuit of an electronic device according to a third embodiment of the present invention.
FIG. 6 is a partially enlarged cross-sectional view of a socket device for testing a circuit of an electronic device according to a fourth embodiment of the present invention.
FIG. 7 is a cross-sectional view of a socket device for testing a circuit of an electronic device according to a fifth embodiment of the present invention.
FIG. 8 is a partially exploded perspective view of a socket device for testing a circuit of an electronic device according to a fifth embodiment of the present invention.

### MODES OF THE INVENTION

Hereinafter, with reference to the attached drawings, embodiments of the present invention will be described in detail so that those skilled in the art can easily practice the present invention. The present invention may be implemented in various different forms and is not limited to the embodiments described herein. In order to clearly describe the present invention, parts that are not related to the description are omitted in the drawings, and the same reference numerals are assigned to the same or similar components throughout the specification.

The words and terms used in the present specification and claims should not be construed as limited to their usual or dictionary meanings, but should be interpreted as having meanings and concepts consistent with the technical idea of the present invention, in accordance with the principles by which the inventor can define terms and concepts in order to best describe his or her invention.

Therefore, the embodiments described in the present specification and the configurations illustrated in the drawings correspond to preferred embodiments of the present invention and do not represent all of the technical ideas of the present invention, and therefore, the configurations may have various equivalents and modified examples that can replace them at the time of filing of the present invention.

In the present specification, it should be understood that terms such as "include" or "have" are intended to describe the presence of a feature, number, step, operation, component, part or combination thereof described in the specification, but do not exclude in advance the possibility of the presence or addition of one or more other features, numbers, steps, operations, components, parts or combinations thereof.

When a component is said to be "in front of," "behind," "above" or "below" another component, unless there are special circumstances, it includes not only being positioned "in front of," "behind," "above" or "below" the other component in direct contact with it, but also cases where there are other components intervening therebetween. In addition, when a component is said to be "connected" to another component, unless there are special circumstances, it includes cases where they are indirectly connected to each other as well as cases where they are directly connected to each other.

Hereinafter, a socket device 100 for testing a circuit of an electronic device according to an embodiment of the present invention will be described with reference to the drawings.

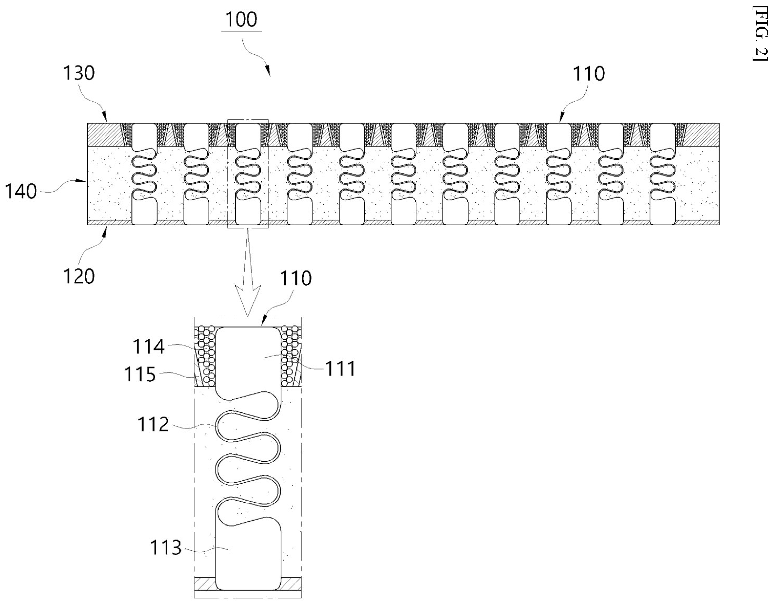

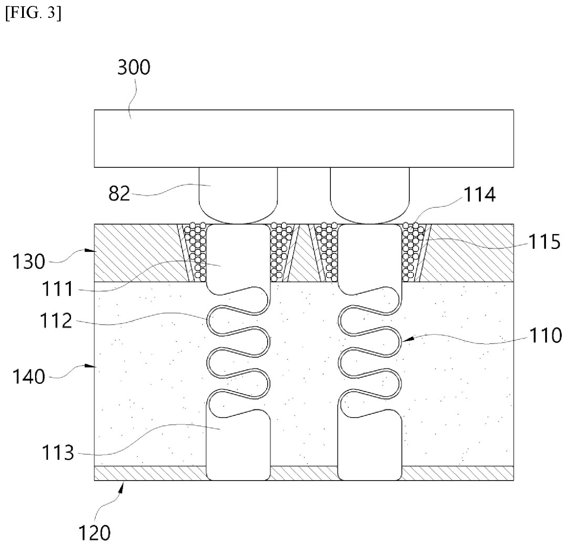

The socket device 100 for testing a circuit of an electronic device according to a first embodiment of the present invention may include a MEMS pin 110, a rubber layer 140 and a metal powder layer 114, as shown in FIGS. 2 and 3.

The MEMS pin 110, referring to FIGS. 2 and 3, may be provided with an upper body 111, a lower body 113 and an elastic connection portion 112 configured to connect the upper body 111 and the lower body 113.

In this case, the upper body 111 and the lower body 113 of the MEMS pin 110 may be formed in a panel shape, and may have a square shape.

In this case, the elastic connection portion 112 of the MEMS pin 110 connects the upper and lower bodies 111, 113, but is formed thinly and in a zigzag shape such that it can be formed in the shape of a two-dimensional spring, for example.

In this case, a terminal 82 of a testing target 300 may come into contact with the upper body 111 of the MEMS pin 110, and a PCB terminal of the testing device may come into contact with the lower body 113.

Referring to FIGS. 2 and 3, the rubber layer 140 may be provided with a through-hole 115 such that the MEMS pin 110 can be embedded in a state where the MEMS pin 110 is supported in a standing position.

In this case, the through-hole 115 of the rubber layer 140 may be manufactured by pouring liquid silicone rubber and hardening while the MEMS pin 110 is in a standing position. Accordingly, the MEMS pin 110 may be completely fixed and embedded in the rubber layer 140.

Alternatively, the silicone rubber may be hardened to form a rubber layer 140, a through-hole 115 may be formed in the rubber layer 140, and then, the MEMS pin 110 may be inserted into the through-hole 115. In this case, the MEMS pin 110 may be installed in a force-fit manner into the through-hole 115 of the rubber layer 140.

In this case, since the rubber layer 140 has a material of silicone rubber, it is a very elastic and flexible material, and thus, even when the terminal 82 of the testing target 300 or the PCT terminal of the testing device is separated from each other, they may come into contact when pressure is applied.

In this case, the through-hole 115 of the rubber layer 140 may be formed in a tapered shape. By forming the through-hole 115 in a tapered shape, stable contact between the metal powders may be achieved.

In this case, an upper film 130 and a lower film 120 may be bonded to the upper and lower surfaces of the rubber layer 140 so as to support the MEMS pin 110. That is, when manufacturing the rubber layer 140, the upper film 130 and the lower film 120 may serve as a frame for the liquid silicone rubber.

Certainly, the upper film 130 and the lower film 120 may be removed after manufacturing, or a separate jig may be manufactured instead of the upper film 130 and the lower film 120 to replace a mold for manufacturing the rubber layer.

In this case, the through-hole 115 of the rubber layer 140 through which the MEMS pin 110 penetrates may be empty without being supplied with a rubber material, or may be filled with a softer rubber material than other parts.

In this case, the rubber layer 140 in which the lower body 113 and the upper body 111 of the MEMS pin 110 are arranged may be filled with different rubber materials, and a rubber material filled around the upper body 111 may be softer than a rubber material filled around the lower body 113.

In this case, a rubber material may not be provided only around the elastic connection portion 112 of the MEMS pin 110, and thus, an air layer may be formed. In this case, the flexibility of the elastic connection portion 112 may be improved, and as a result, the flexibility may be improved generally throughout the entire rubber layer 140.

The metal powder layer 114, referring to FIGS. 2 and 3, may include a plurality of metal powders fixed between the MEMS pin 110 and the rubber layer 140 so as to surround the MEMS pin 110.

In this case, the metal powder layer 114 may be disposed to surround the entire MEMS pin 110, or may be disposed to surround only the upper body 111 or lower body 113 of the MEMS pin 110.

In this case, the metal powder layer 114 may be manufactured by providing a plurality of metal powders in a partially closed space and supplying a bonding material that is capable of fixing and bonding the same. In this way, the metal powders may be fixed by bonding to each other while maintaining a state of electrical connection by contacting each other.

In this case, the metal powder layer 114 produced in this way has a jelly-like form and may move flexibly while also allowing current to flow.

In this case, when the metal powder layer 114 is installed to surround the upper body 111 of the MEMS pin 110, the space of the through-hole 115 through which the metal powder is supplied may have a tapered shape. That is, the diameter of the metal powder layer 140 at an upper part may be formed to be larger than that at a lower part.

By forming in this way, the metal powder may be more reliably adhered to the upper body 111 of the MEMS pin 110, and the contact area through which the upper part can electrically contact the terminal 82 of the testing target 300 may be increased.

Referring to FIG. 2, the cross-sectional view of a socket device for testing a circuit of an electronic device according to a first embodiment of the present invention is illustrated. Referring to FIG. 3, the partially enlarged cross-sectional view of a socket device for testing a circuit of an electronic device according to a first embodiment of the present invention is illustrated.

In the illustrated embodiment, a plurality of MEMS pins 110 are embedded into the rubber layer 140 in a standing position. The MEMS pin 110 is composed of an upper body 111 and a lower body 113 like a typical MEMS pin 110, and includes an elastic connection portion 112 configured to connect the same. The MEMS pin 110 may be formed in a thin plate shape.

In this case, an upper film 111 and a lower film 113 are installed on the upper and lower ends of the rubber layer 140, respectively.

In this case, since the MEMS pin 110 is embedded through the upper and lower films 111, 113 and the rubber layer 140, a through-hole 115 is formed in each.

In this case, the through-hole 115 of the upper film 130 is formed in a tapered shape and is spaced apart from the upper body 111, and a metal powder layer 114 is installed between the same to surround the upper body 111.

Therefore, the testing current may flow through the upper body 111, the metal powder layer 114, the elastic connection portion 112 and the lower body 113.

In FIG. 2, a terminal 82 of a testing target 300 is a BGA type terminal. In the illustrated embodiment, the terminal 82 is in contact with the upper body 111 such that testing current can flow.

In this case, since the upper body 111 is thin, there may be cases where it is separated from the terminal 82 and does not make contact. In this case, since the terminal 82 is in contact with the metal powder layer 114, the testing current may eventually flow through the upper body 111, the elastic connection portion 112 and the lower body 113.

Here, since the through-hole 115 is formed in a tapered shape and the area of the upper part of the metal powder layer 141 is larger than that of the lower part, electrical contact may be made over a wide area, thereby preventing testing defects due to non-contact through a stable flow of testing current.

In this case, the case where it is used with the upper and lower films 130, 120 is shown here, but it is of course possible to use the same with the film removed, that is, with only the rubber layer 140.

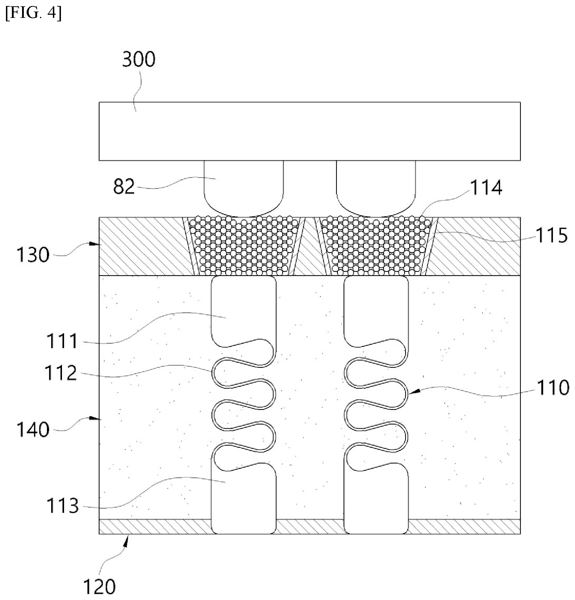

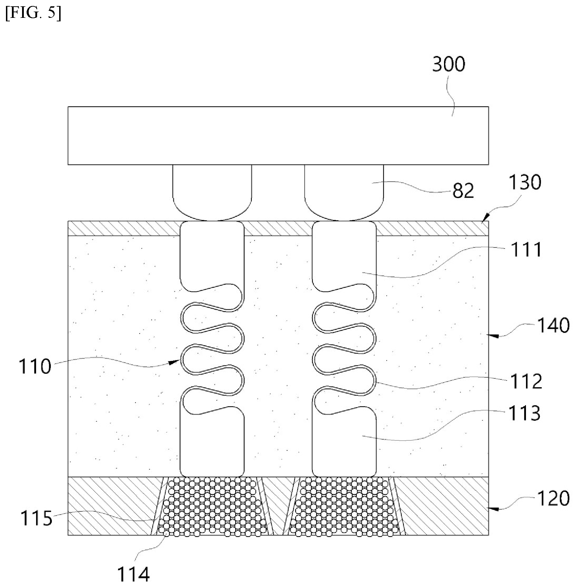

Meanwhile, referring to FIG. 4, the partially enlarged cross-sectional view of a socket device for testing a circuit of an electronic device according to a second embodiment of the present invention is illustrated, and referring to FIG. 5, the partially enlarged cross-sectional view of a socket device for testing a circuit of an electronic device according to a third embodiment of the present invention is illustrated.

In the illustrated embodiment, the socket device for testing a circuit of an electronic device may include a MEMS pin 110 having an upper body 111, a lower body 113 and an elastic connection portion 112 configured to connect the upper body 111 and the lower body 113, a rubber layer 140 having a through-hole in which the MEMS pin 110 is embedded while the MEMS pin 110 is supported in a standing position, and a metal powder layer 114 including a plurality of metal powders filled and fixed in a recessed portion 215 in which a part of the rubber layer 140 is recessed at a position where an upper or lower end part of the MEMS pin 110 is disposed.

The difference between the second and third embodiments of the present invention is that the recessed portion 215 where the metal powder layer 114 is formed is formed at the upper end or lower end of the rubber layer 140.

In the illustrated embodiment, the metal powder layer 114 is not installed to wrap around the upper and lower bodies 111, 113 of the MEMS pin 110, but is disposed at the upper or lower end such that only the metal powder layer 114 can directly contact the terminals 82, which is different from the previous embodiments.

In this case, it is certain that the recessed portion 215 where the metal powder layer 114 is disposed may be disposed directly on the rubber layer 140 in the absence of upper and lower films, in addition to the upper and lower films 130, 120.

In this case, the shape of the recessed portion 215 where the metal powder layer 114 is disposed may also be formed into a tapered shape.

In this case, the recessed portion 215 may preferably have a larger area so as to cover the area of the end of the upper body 111 or the lower body 113 of the MEMS pin 110.

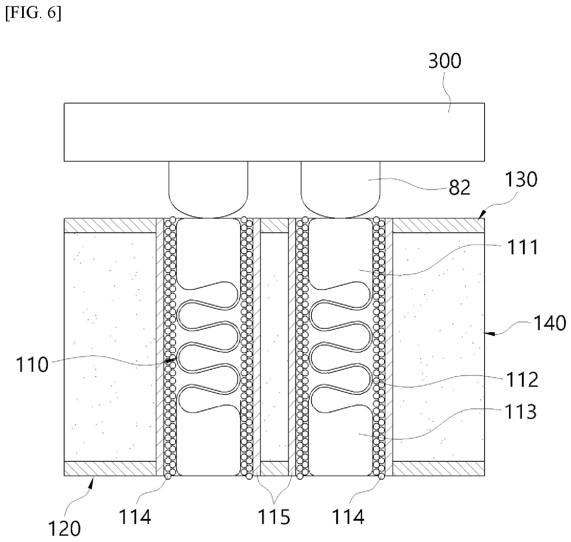

Meanwhile, referring to FIG. 6, the partially enlarged cross-sectional view of a socket device for testing a circuit of an electronic device according to a fourth embodiment of the present invention is illustrated.

In the illustrated embodiment, there is a difference in that, unlike the first embodiment, the metal powder layer 114 is installed not to surround only the upper and lower bodies of the MEMS pin 110, but to surround the entire MEMS pin 110.

By forming the metal powder layer 114 over the entire MEMS pin 110 in this way, the metal powder layer 114 may be in contact with not only the upper and lower bodies 111, 113 but also the elastic connection portion 112. Accordingly, even if there is a partial contact failure, for example, a partial disconnection of the elastic connection portion 112, the testing current may flow to the upper and lower ends of the MEMS pin 110.

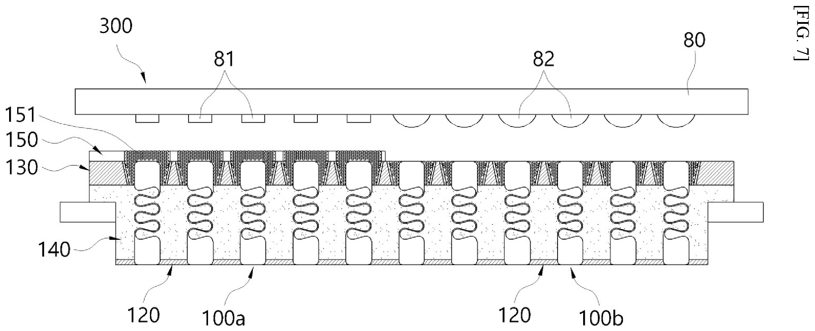

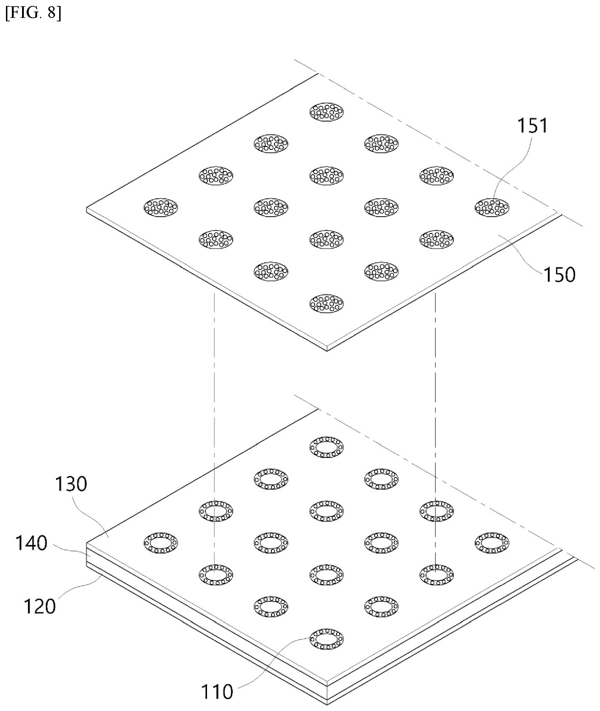

Meanwhile, referring to FIG. 7, the cross-sectional view of a socket device for testing a circuit of an electronic device according to a fifth embodiment of the present invention is illustrated, and referring to FIG. 8, the partially exploded perspective view of a socket device for testing a circuit of an electronic device according to a fifth embodiment of the present invention is illustrated.

In the illustrated embodiment, the socket device 100 that is capable of testing an electronic device 300 having different types of terminals is illustrated.

In the illustrated embodiment, a terminal 81 on the left side of the electronic device 300 is an LGA-type terminal, and the terminal 82 on the right side is a BGA-type terminal. Accordingly, there are multiple types of terminals of the electronic device 300, and the heights of the terminals also differ depending on the type.

In the illustrated embodiment, the socket device 100 may be manufactured integrally, and if the terminals disposed at the top are different, the socket device may be manufactured as modules by dividing the socket device into different terminals according to the terminal type.

In the illustrated embodiment, the socket device 100 is composed of upper and lower films 120, 130, a rubber layer 140, a MEMS pin 110 and a metal powder layer 114, as described above. The socket device 100 may be manufactured integrally or in multiple pieces according to terminals. Here, it is manufactured in two socket devices 100a, 100b.

In the illustrated embodiment, a rubber film layer 150 may be installed to cover all or part of an upper part of the rubber layer 140, and may have a connection terminal or metal powder layer 151 at each position corresponding to the MEMS pin 110 and the metal powder layer 114 such that the height can be adjusted for all or part of the multiple terminals 81, 82.

In this case, the rubber film layer 150 is replaceable.

In this case, the rubber film layer 150 may correspond to a step of the terminal 81, 82, is made of the same silicon rubber as the rubber layer 140, and a connecting terminal or a metal powder layer 151 may be fixed at the positions of the terminals 81, 82.

In this case, since the rubber film layer 150 is replaceable, it is easy to replace a new rubber film layer when the shelf life is reached.

Although the embodiments of the present invention have been described, the concept of the present invention is not limited to the embodiments presented in the present specification, and those skilled in the art who understand the concept of the present invention will be able to easily propose other embodiments by adding, changing, deleting or supplementing components within the scope of the same concept, but this will also be considered to fall within the concept of the present invention.

### INDUSTRIAL APPLICABILITY

The present invention can be applied to the testing of semiconductor devices, which are microscopic electronic components.

## Claims

1. A socket device for testing a circuit of an electronic device, comprising:
a MEMS pin having an upper body, a lower body and an elastic connection portion configured to connect the upper body and the lower body;
a rubber layer having a through-hole in which the MEMS pin is embedded while being supported in a standing position; and
a metal powder layer comprising a plurality of metal powders and fixed between the MEMS pin and the rubber layer so as to surround the MEMS pin.

2. A socket device for testing a circuit of an electronic device, comprising:
a MEMS pin having an upper body, a lower body and an elastic connection portion configured to connect the upper body and lower body;
a rubber layer having a through-hole in which the MEMS pin is embedded while being supported in a standing position; and
a metal powder layer comprising a plurality of metal powders that are filled into and fixed in a recessed portion formed where a part of the rubber layer is recessed at a position where an upper or lower end part of the MEMS pin is disposed.

3. The socket device of claim 1 or 2, wherein a through-hole of the rubber layer has a tapered shape.

4. The socket device of claim 1 or 2, wherein an upper film and a lower film are bonded to upper and lower surfaces of the rubber layer so as to support the MEMS pin.

5. The socket device of claim 1 or 2, wherein a through-hole of a rubber layer through which the MEMS pin penetrates is not supplied with a rubber material and is empty.

6. The socket device of claim 1 or 2, wherein a through-hole of a rubber layer through which the MEMS pin penetrates is filled with a softer rubber material than other parts.

7. The socket device of claim 1 or 2, wherein rubber layers on which a lower body and upper body of the MEMS pin are disposed are filled with different rubber materials, and a rubber material filled in the upper body is softer than a rubber material filled in the lower body.

8. The socket device of claim 1 or 2, wherein an elastic connection portion of the MEMS pin is not provided with a rubber material and is formed with an air layer.

9. The socket device of claim 1, wherein the metal powder layer is disposed to surround the entire MEMS pin, or to surround only an upper body or lower body of the MEMS pin.

10. The socket device of claim 2, wherein the recessed portion has a larger area so as to cover an area of an end part of an upper body or lower body of the MEMS pin.

11. The socket device of claim 1 or 2, further comprising:
a rubber film layer installed to cover all or part of an upper part of the rubber layer, and having connection terminals at each position corresponding to the MEMS pin such that a height is adjusted for all or part and applied to multiple terminals.

12. The socket device of claim 11, wherein the rubber film layer is replaceable.

13. The socket device of claim 1 or 2, wherein the rubber layer is made of silicone rubber.
